(19) Europäisches Patentamt
European Patent Office
Office européen des brevets

(11) **EP 1 726 094 B1**

(12) **EUROPÄISCHE PATENTSCHRIFT**

(45) Veröffentlichungstag und Bekanntmachung des Hinweises auf die Patenterteilung:
**26.05.2010 Patentblatt 2010/21**

(21) Anmeldenummer: **05716932.8**

(22) Anmeldetag: **07.03.2005**

(51) Int Cl.:
*H03K 19/00* (2006.01)

(86) Internationale Anmeldenummer:
**PCT/EP2005/051000**

(87) Internationale Veröffentlichungsnummer:
**WO 2005/091504 (29.09.2005 Gazette 2005/39)**

(54) **REKONFIGURIERBARE DIGITALE LOGIKEINHEIT**

RECONFIGURABLE DIGITAL LOGIC UNIT

UNITE LOGIQUE NUMERIQUE RECONFIGURABLE

(84) Benannte Vertragsstaaten:
**DE FR GB**

(30) Priorität: **15.03.2004 DE 102004012531**

(43) Veröffentlichungstag der Anmeldung:
**29.11.2006 Patentblatt 2006/48**

(73) Patentinhaber: **SIEMENS AKTIENGESELLSCHAFT**
**80333 München (DE)**

(72) Erfinder: **BANGERT, Joachim**
**91052 Erlangen (DE)**

(56) Entgegenhaltungen:
**DE-A1- 10 237 876     DE-C1- 19 922 129**

**Beschreibung**

Die Erfindung betrifft eine rekonfigurierbare digitale Logikeinheit mit wenigstens einem Logikgatter mit ein magnetisches Schichtsystem aufweisenden Zellen, deren Widerstand durch Magnetfeldpulse veränderbar ist, welches Logikgatter wenigstens einen ersten Leitungszweig mit wenigstens einer Datenzelle und einen parallel dazu geschalteten zweiten Leitungszweig mit wenigstens einer Referenzzelle sowie ein Mittel zum Bewerten der ein Maß für den logischen Zustand des Logikgatters darstellenden Widerstände des ersten und zweiten Leitungszweigs umfasst, wobei dass der erste Leitungszweig wenigstens zwei parallel geschaltete Datenzellen aufweist und dass die sich entsprechenden Enden des ersten und des zweiten Leitungszweiges jeweils an einem gemeinsamen Schaltungsknoten zusammengeführt sind.

Derartige Zellen ermöglichen die Speicherung von Informationen auf magnetischer Basis. Die Magnetisierung einer Schicht des magnetischen Schichtsystems kann durch einen Magnetfeldpuls geändert werden, so dass sich der Magnetowiderstand dieser Schichtstruktur um einige Prozent ändert. Der jeweilige Widerstand kann ausgelesen werden und ist ein Maß für den logischen Zustand der Zelle.

Allerdings sind die Anwendungsmöglichkeiten derartiger digitaler Logikeinheiten bisher stark eingeschränkt. Eines der praktischen Probleme besteht darin, dass der TMR-Widerstand (tunnel magneto resistive) vor allem von der gewählten Stromrichtung abhängt. Möglicherweise sind unterschiedliche Materialien auf den beiden Barrierenseiten die Ursache dafür.

Die DE 199 22 129 C1 beschreibt eine Vorrichtung zur logischen Verknüpfung von Signalen auf magnetoresistiver Basis. Dabei werden an Eingängen anliegende Eingangssignale zu an einem oder mehreren Ausgängen anliegenden, festen Ausgangssignalen verknüpft. Dabei handelt es sich um feste, unveränderliche Schaltungen, die weder reprogrammierbar noch rekonfigurierbar sind.

Eine so genannte analoge Referenzzelle ist in der DE 102 37 876 A1 beschrieben. Eine analoge Referenzzelle ist ein Bauelement, das nach der Einstellung durch entsprechende Mittel einen gewissen Normwiderstand liefert. Damit bildet die analoge Referenzzelle ein Bauteil einer Logikreferenzzelle, die ein Signal speichern kann und durch ein Konfigurationssignal einstellbar ist.

Der Erfindung liegt daher das Problem zugrunde, eine rekonfigurierbare digitale Logikeinheit zu schaffen, bei der die Lesestromrichtung für alle Zellen gleich ist.

Zur Lösung dieses Problems ist bei einer rekonfigurierbaren digitalen Logikeinheit der eingangs genannten Art erfindungsgemäß vorgesehen, dass der erste Leitungszweig wenigstens zwei parallel geschaltete Datenzellen aufweist, und dass die sich entsprechenden Enden des ersten und des zweiten Leitungszweiges jeweils an einem gemeinsamen Schaltungsknoten zusammengeführt sind.

Der erste Leitungszweig des Logikgatters der erfindungsgemäßen rekonfigurierbaren digitalen Logikeinheit umfasst wenigstens eine Datenzelle, die durch Magnetfeldpulse programmiert werden kann, indem der Widerstand der Datenzelle durch Anlegen von Magnetfeldpulsen geändert werden kann. Der Unterschied zwischen den beiden einstellbaren Zuständen wird als TMR-Signalhub bezeichnet. Die in dem parallelen, zweiten Leitungszweig angeordnete Referenzzelle ist ebenfalls eine TMR-Zelle mit einem magnetischen Schichtsystem. Die Referenzzelle kann eine vorprogrammierte Zelle sein, es kann sich jedoch auch um eine reprogrammierbare Zelle handeln. In beiden Fällen bleibt die jeweilige Programmierung nicht flüchtig erhalten und bestimmt die Funktion des Logikgatters. Erfindungsgemäß ist ein Mittel zum Bewerten der Widerstände des ersten und zweiten Leitungszweigs vorgesehen sein. Diese Widerstände sind ein Maß für den logischen Zustand des Logikgatters.

Das Mittel zum Bewerten der Widerstände des ersten und zweiten Leitungszweigs kann als Komparator ausgebildet sein. In diesem Fall werden die Widerstände der beiden Leitungszweige einzeln bewertet.

Alternativ kann es bei der erfindungsgemäßen Logikeinheit vorgesehen sein, dass das Mittel als Parallelschaltung des ersten und zweiten Leitungszweiges ausgebildet ist und der Gesamtwiderstand der Parallelschaltung bewertbar ist. Bei dieser Variante der Erfindung werden die Widerstände gemeinsam bewertet. Die Parallelschaltung bewirkt, dass die Referenzzellen den TMR-Signalhub des Logikgatters beeinflussen.

Gemäß einer Weiterbildung der erfindungsgemäßen rekonfigurierbaren digitalen Logikeinheit kann es vorgesehen sein, dass der zweite Leitungszweig wenigstens zwei parallel geschaltete Referenzzellen aufweist. Die parallel geschalteten Zellen eines jeden Leitungszweigs können separat programmierbar sein, wodurch sich weitere Anwendungsmöglichkeiten ergeben. Es ist nicht erforderlich, dass die Anzahl der Zellen in dem ersten Leitungszweig mit der Anzahl der Zellen in dem zweiten Leitungszweig übereinstimmt, sondern die beiden Leitungszweige können eine unterschiedliche Anzahl von Zellen aufweisen.

Gemäß einer Weiterbildung der Erfindung kann der erste Leitungszweig mehrere in Reihe geschaltete Datenzellen und der zweite Leitungszweig mehrere in Reihe geschaltete Referenzzellen aufweisen. Dabei wird es besonders bevorzugt, dass jeder in Reihe geschalteten Datenzelle eine Referenzzelle zugeordnet ist.

Mit besonderem Vorteil kann der Ausgang eines Logikgatters mit einem weiteren Gatter verbunden oder verbindbar sein, um dieses anzusteuern. Anders als bei im Stand der Technik bekannten Logikgattern mit magnetischen Schichtsystemen reicht gegebenenfalls der Strom bei der erfindungsgemäßen digitalen Logikeinheit um ein weiteres Gatter anzusteuern, da der Gesamtwiderstand der Parallelschaltung stets kleiner als der kleinste der Widerstände ist.

Ein weiterer Vorteil der erfindungsgemäßem Logikeinheit ist darin zu sehen, dass die Zellen des Logikgatters dieselbe Lesestromrichtung aufweisen. Dadurch wird der Nachteil vermieden, dass TMR-Zellen in unterschiedlichen Richtungen vom Strom durchflossen werden, was zu Problemen bei der Signalauswertung führen kann.

Bei der erfindungsgemäßen Logikeinheit wird es besonders bevorzugt, dass der Widerstand einer Zelle durch Magnetfeldpulse um bis zu etwa 60 % veränderbar ist.

In weiterer Ausgestaltung der Erfindung können die zwei parallelen Widerstände des ersten Leitungszweigs näherungsweise übereinstimmen, so dass eine dreiwertige Logik geschaffen wird. Die dreiwertige Logik besitzt die Zustände wahr, falsch und indifferent. Bei dreiwertiger Logik wird es besonders bevorzugt, dass die Widerstandsänderung für den dritten Zustand zwischen low (0 %) und high (z.B. 60 %) liegt. Ein derartiges Logikgatter kann für die Gatterfunktionen NOR, NAND, OR, AND, const. eingesetzt werden.

In weiterer Ausgestaltung der Erfindung kann einer der Widerstände des ersten Leitungszweigs näherungsweise 5/3 des anderen Widerstands betragen. In diesem Fall wird eine vierwertige Logik geschaffen, die die Widerstandsstufen high, medium-high, medium-low, low umfasst. Ein derartiges Logikgatter kann für die Gatterfunktionen OR, var, AND, const., NOR, NAND eingesetzt werden.

Die erfindungsgemäße rekonfigurierbare digitale Logikeinheit kann Logikgatter in zweiwertiger und/ oder dreiwertiger und/oder vierwertiger Logik umfassen.

Die Logikeinheit kann als feldprogrammierbare Logikeinheit ausgebildet sein, alternativ ist es jedoch auch möglich, dass sie als maskenprogrammierbare Logikeinheit ausgebildet ist.

Weitere Vorteile und Einheiten der Erfindung ergeben sich aus dem im folgenden beschriebenen Ausführungsbeispiel unter Bezugnahme auf die Zeichnungen. Dabei zeigt:

Fig. 1 eine erfindungsgemäße Logikeinheit mit einer Daten- zelle und einer dazu parallelen Referenzzelle;

Fig. 2 ein Diagramm des TMR-Signalhubs für die verschiede- nen Zustände der Zellen bei dreiwertiger Logik;

Fig. 3 ein Diagramm des TMR-Signalhubs bei vierwertiger Logik; und

Fig. 4 eine erfindungsgemäße Logikeinheit, bei der der durchfließende Strom als Eingangssignal der nächs- ten Stufe weiter verarbeitet wird.

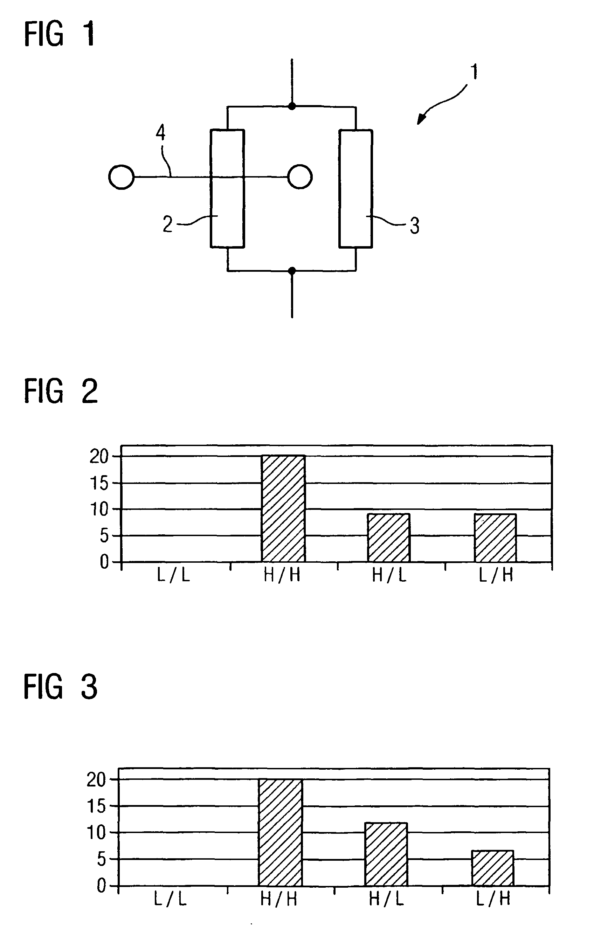

Die in Fig. 1 gezeigte Logikeinheit 1 besteht aus einer Datenzelle 2 und einer parallel dazu geschalteten Referenzzelle 3. Die Zellen 2, 3 weisen jeweils ein magnetisches Schichtsystem auf, dessen Magnetisierung über ein angelegtes magnetisches Feld zwischen zwei Zuständen umgeschaltet werden kann. Die beiden Zustände können als Informationsbit interpretiert werden und stellen die logischen Zustände 0 und 1 bzw. Low und High dar. Der Magnetowiderstand ändert sich in Abhängigkeit dieser Zustände im Prozentbereich, so dass die Widerstandsänderung zum Auslesen von in der Zelle abgelegten Informationen verwendet werden kann.

Die Datenzelle 2 kann durch einen Magnetfeldpuls, der an die Eingangsleitung 4 angelegt wird, programmiert werden. Die programmierte Zelle 3 kann entweder reprogrammierbar oder eine konstante Referenzzelle sein. Die Programmierung bleibt nicht flüchtig erhalten und bestimmt die Funktionen des Logikgatters.

Beide Zellen lassen sich von ihrem minimalen Widerstand R1 bzw. R2 um den TMR-Signalhub m in einen höheren Widerstandswert umschalten. Dadurch ergeben sich vier verschiedene Kombinationen, deren Gesamtwiderstand wie folgt berechnet werden kann:

minimaler Widerstand (R1 = Low / R2 = Low)

$$Rges = \frac{R1 \cdot R2}{R1 + R2}$$

Zwischenzustand 1 (R1 = Low / R2 = High)

$$Rges = \frac{R1 \cdot (1 + m) \cdot R2}{R1 \cdot (1 + m) + R2}$$

Zwischenzustand 2 (R1 = High / R2 = Low)

$$Rges = \frac{R1 \cdot R2 \cdot (1 + m)}{R1 + R2 \cdot (1 + m)}$$

minimaler Widerstand (R1 = High / R2 = High)

$$Rges = \frac{R1 \cdot R2}{R1 + R2} \cdot (1 + m)$$

Wenn beide Gatter mit dem gleichen Strom (Low / Low oder High / High) programmiert werden, ergibt sich keine von außen messbare Änderung des TMR-Signalhubs, sondern nur eine Halbierung des Gesamtwiderstands. Durch die Zwischenstufen ergeben sich jedoch zusätzliche Funktionalitäten.

Im einfachsten Fall, wenn R2 = R1 gewählt wird, ergeben sich identische Widerstandsstufen. Diese Zustände sind insbesondere bei dreiwertiger Logik mit den Zuständen wahr, falsch und indifferent von Bedeutung.

Fig. 2 zeigt ein Diagramm des TMR-Signalhubs für die verschiedenen Zustände der Zellen als Funktion der Widerstände. Auf der X-Achse sind die jeweiligen Kombinationen der Widerstände R1 und R2 dargestellt. Der prozentuale TMR-Signalhub als Funktion der Widerstände ist auf der Y-Achse dargestellt. Der Maximalwert, der sich bei dem Zustand H/H ergibt, entspricht einem TMR-Signalhub von 20 %. Der TMR-Signalhub ist der Anstieg oder Zuwachs, um den der Widerstand ausgehend von dem minimalen Widerstand, z.B. R1, angehoben werden kann.

Der Signalhub der Zwischenstufen beträgt in diesem Fall 9,1 %. Auf diese Weise kann die Logikeinheit für dreiwertige Logik eingesetzt werden.

Fig. 3 ist ein Diagramm des TMR-Signalhubs bei vierwertiger Logik.

In diesem Fall können die Widerstände R1 und R2 so gewählt werden, dass sich vier Stufen im TMR-Signalhub ausbilden, die den gleichen Abstand zueinander haben. Dieses wird bei R2 = 1,667 R1 bzw. R2 = 5/3 R1 erreicht. Anders als in dem Diagramm von Fig. 2 unterscheiden sich nun die Zwischenstufen H/L und L/H voneinander.

Neue Funktionen ergeben sich durch die Kombinationen herkömmlicher (zweiwertiger), dreiwertiger und vierwertiger Logik auf einem Chip. Dazu können jeweils mehrere Funktionsgatter und mehrere Programmiergatter parallel geschaltet werden. Es ist nicht erforderlich, dass jeweils der gleiche TMR-Signalhub vorhanden ist. Ebenso spielt der Flächenwiderstand keine entscheidende Rolle, da die Eigenschaften über die Fläche der einzelnen Zellen eingestellt werden können.

Die in Fig. 1 gezeigte Logikeinheit und entsprechende Schaltungen lassen sich besonders gut mit feldprogrammierbarer Logik verwirklichen, alternativ kann die feldprogrammierbare Logik auch mit der maskenprogrammierbaren Logik verknüpft werden, indem Daten- oder Referenzzellen bei Bedarf weggelassen werden.

Grundsätzlich kann die Anordnung der Zellen, durch die der gleiche Strom zur Bestimmung des Widerstands fließen soll, als Anordnung von Einzelzellen nebeneinander, aber auch übereinander ausgeführt werden, wenn ein Schichtsystem mit mehreren identischen Funktionslagen vorliegt.

Anstelle der Verwendung einer einzigen Zelle können mehrere Zellen parallel geschaltet werden, um einen Mittelwert der Widerstände zu bilden. Dabei ist der Programmier- oder Datenstrom für alle Zellen gleich. Der Zellwiderstand bleibt unabhängig von der Reihen- oder Parallelschaltung erhalten.

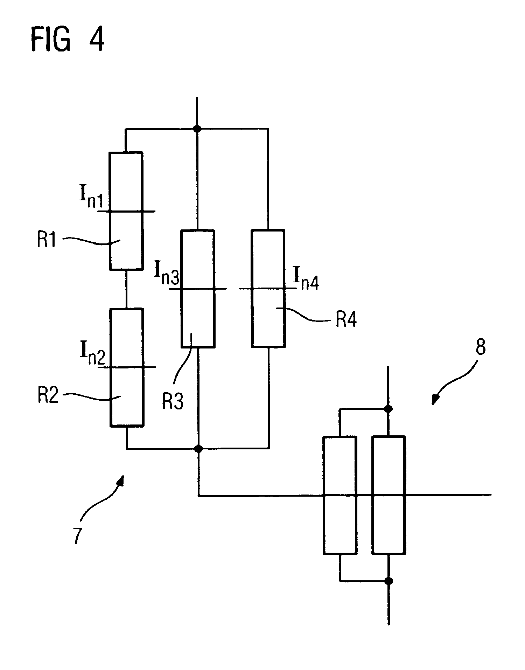

Fig. 4 zeigt Teile einer Logikeinheit, bei der der durchfließende Strom als Eingangssignal der nächsten Stufe weiterverarbeitet wird.

Die erste Logikeinheit 7 umfasst einen Block von Referenz- oder Datenzellen mit Eingängen In1 - In4 und Widerständen $R_1$ - $R_4$, die einzeln konfigurierbar sind und Funktionszellen 8 einer zweiten Logikeinheit. Der Ausgang der Zellen 7 dient als Eingangssignal für die Funktionszellen 8. Bei geschichteten Zellen kann der durchfließende Strom auch in darüber oder darunter liegende Funktionslagen geführt werden. Auf diese Weise lassen sich größere Logikschaltungen realisieren, die zweiwertige, dreiwertige und höherwertige Logik umfassen.

**Patentansprüche**

1. Rekonfigurierbare digitale Logikeinheit (1) mit wenigstens einem Logikgatter mit ein magnetisches Schichtsystem aufweisenden Zellen, deren Widerstand durch Magnetfeldpulse veränderbar ist, welches Logikgatter wenigstens einen ersten Leitungszweig mit wenigstens einer Datenzelle (2) und einen parallel dazu geschalteten zweiten Leitungszweig mit wenigstens einer Referenzzelle (3) sowie ein Mittel (4) zum Bewerten der ein Maß für den logischen Zustand des Logikgatters darstellenden Widerstände des ersten und zweiten Leitungszweigs umfasst, **dadurch gekennzeichnet, dass** der erste Leitungszweig wenigstens zwei parallel geschaltete Datenzellen (2) aufweist und dass die sich entsprechenden Enden des ersten und des zweiten Leitungszweiges jeweils an einem gemeinsamen Schaltungsknoten zusammengeführt sind.

2. Rekonfigurierbare digitale Logikeinheit nach Anspruch 1, **dadurch gekennzeichnet, dass** das Mittel zum Bewerten der Widerstände des ersten und zweiten Leitungszweigs als Komparator ausgebildet ist.

3. Rekonfigurierbare digitale Logikeinheit nach Anspruch 1, **dadurch gekennzeichnet, dass** das Mittel als Parallelschaltung des ersten und zweiten Leitungszweiges ausgebildet ist und der Gesamtwiderstand der Parallelschaltung bewertbar ist.

4. Rekonfigurierbare digitale Logikeinheit nach einem der vorangehenden Ansprüche, **dadurch gekennzeichnet, dass** der zweite Leitungszweig wenigstens zwei parallel geschaltete Referenzzellen (3) aufweist.

5. Rekonfigurierbare digitale Logikeinheit nach Anspruch 4, **dadurch gekennzeichnet, dass** sich die Anzahl der Zellen in dem ersten Leitungszweig von der Anzahl der Zellen in dem zweiten Leitungszweig unterscheidet.

6. Rekonfigurierbare digitale Logikeinheit nach einem der vorangehenden Ansprüche, **dadurch gekennzeichnet, dass** der erste und der zweite Leitungszweig in Reihe und/oder parallel geschaltete Zellen aufweisen.

7. Rekonfigurierbare digitale Logikeinheit nach einem der vorangehenden Ansprüche, **dadurch gekennzeichnet, dass** der Ausgang eines Logikgatters, das vorzugsweise eine Datenzelle und eine parallel geschaltete Referenzzelle aufweist, mit einem weiteren Gatter verbunden oder verbindbar ist um dieses anzusteuern.

8. Rekonfigurierbare digitale Logikeinheit nach einem der vorangehenden Ansprüche, **dadurch gekennzeichnet, dass** die Zellen (7) des Logikgatters dieselbe Lesestromrichtung aufweisen.

9. Rekonfigurierbare digitale Logikeinheit nach einem der vorangehenden Ansprüche, **dadurch gekennzeichnet, dass** der Widerstand einer Zelle (2, 3) durch Magnetfeldpulse um bis zu 60 % veränderbar ist.

10. Rekonfigurierbare digitale Logikeinheit nach einem der vorangehenden Ansprüche, **dadurch gekennzeichnet, dass** zur Schaffung einer dreiwertigen Logik die Widerstände in einem Leitungszweig näherungsweise übereinstimmen und die Widerstandsänderung von dem Low-Wert auf den unterhalb des High-Werts liegenden Zwischenwert der dreiwertigen Logik vorzugsweise näherungsweise die Hälfte der Widerstandsänderung vom Low-Wert zum High-Wert beträgt.

11. Rekonfigurierbare digitale Logikeinheit nach Anspruch 10, **dadurch gekennzeichnet, dass** das Logikgatter die Widerstandsstufen high, medium und low umfasst.

12. Rekonfigurierbare digitale Logikeinheit nach Anspruch 10 oder 11, **dadurch gekennzeichnet, dass** das Logikgatter für eine der folgenden Gatterfunktionen einsetzbar ist: NOR, NAND, OR, AND, const.

13. Rekonfigurierbare digitale Logikeinheit nach einem der Ansprüche 1 bis 9, **dadurch gekennzeichnet, dass** zur Schaffung einer vierwertigen Logik der Widerstand des ersten Leitungszweigs näherungsweise 5/3 des Widerstands des zweiten Leitungszweigs entspricht.

14. Rekonfigurierbare digitale Logikeinheit nach Anspruch 13, **dadurch gekennzeichnet, dass** das Logikgatter die Widerstandsstufen high, medium-high, medium-low und low umfasst.

15. Rekonfigurierbare digitale Logikeinheit nach Anspruch 13 oder 14, **dadurch gekennzeichnet, dass** das Logikgatter für eine der folgenden Gatterfunktionen einsetzbar ist: OR, var, AND, const, NOR, NAND.

16. Rekonfigurierbare digitale Logikeinheit nach einem der vorangehenden Ansprüche, **dadurch gekennzeichnet, dass** die Logikeinheit Logikgatter in zweiwertiger und/oder dreiwertiger und/oder vierwertiger Logik umfasst.

17. Rekonfigurierbare digitale Logikeinheit nach einem der vorangehenden Ansprüche, **dadurch gekennzeichnet, dass** die Logikeinheit als feldprogrammierbare Logikeinheit ausgebildet ist.

18. Rekonfigurierbare digitale Logikeinheit nach einem der Ansprüche 1 bis 17, **dadurch gekennzeichnet, dass** sie als maskenprogrammierbare Logikeinheit ausgebildet ist.

19. Rekonfigurierbare digitale Logikeinheit nach einem der vorangehenden Ansprüche, **dadurch gekennzeichnet, dass** die das magnetische Schichtsystem aufweisenden Zellen nebeneinander oder übereinander angeordnet sind.

**Claims**

1. Reconfigurable digital logic unit (1) comprising at least one logic gate with cells which have a magnetic layer system and the resistance of which can be altered by means of magnetic field pulses, which logic gate comprises at least one first line branch with at least one data cell (2) and a second line branch - connected in parallel therewith - with at least one reference cell (3), and also a means (4) for evaluating the resistances of the first and second line branches, said resistances representing a measure of the logic state of the logic gate, **characterized in that** the first line branch has at least two data cells (2) connected in parallel, and **in that** the mutually corresponding ends of the first and the second line branch are respectively brought together at a common circuit node.

2. Reconfigurable digital logic unit according to Claim 1, **characterized in that** the means for evaluating the resistances of the first and second line branches is formed as a comparator.

3. Reconfigurable digital logic unit according to Claim 1, **characterized in that** the means is formed as a parallel circuit comprising the first and second line branches and the total resistance of the parallel circuit can be evaluated.

4. Reconfigurable digital logic unit according to one of the preceding claims, **characterized in that** the second line branch has at least two reference cells (3) connected in parallel.

5. Reconfigurable digital logic unit according to Claim 4, **characterized in that** the number of cells in the first line branch differs from the number of cells in the second line branch.

6. Reconfigurable digital logic unit according to one of the preceding claims, **characterized in that** the first and second line branches have cells connected in series and/or in parallel.

7. Reconfigurable digital logic unit according to one of the preceding claims, **characterized in that** the output of a logic gate which preferably has a data cell and a reference cell connected in parallel is connected or can be connected to a further gate in order to drive the latter.

8. Reconfigurable digital logic unit according to one of the preceding claims, **characterized in that** the cells (7) of the logic gate have the same read current direction.

9. Reconfigurable digital logic unit according to one of the preceding claims, **characterized in that** the resistance of a cell (2, 3) can be altered by up to 60% by means of magnetic field pulses.

10. Reconfigurable digital logic unit according to one of the preceding claims, **characterized in that**, in order to create a three-value logic, the resistances in a line branch approximately match and the resistance change from the low value to the intermediate value lying below the high value of the three-value logic preferably amounts to approximately half of the resistance change from the low value to the high value.

11. Reconfigurable digital logic unit according to Claim 10, **characterized in that** the logic gate comprises the resistance levels high, medium and low.

12. Reconfigurable digital logic unit according to Claim 10 or 11, **characterized in that** the logic gate can be used for one of the following gate functions: NOR, NAND, OR, AND, const.

13. Reconfigurable digital logic unit according to one of Claims 1 to 9, **characterized in that**, in order to create a four-value logic, the resistance of the first line branch approximately corresponds to 5/3 of the resistance of the second line branch.

14. Reconfigurable digital logic unit according to Claim 13, **characterized in that** the logic gate comprises the resistance levels high, medium-high, medium-low and low.

15. Reconfigurable digital logic unit according to Claim 13 or 14, **characterized in that** the logic gate can be used for one of the following gate functions: OR, var, AND, const, NOR, NAND.

16. Reconfigurable digital logic unit according to one of the preceding claims, **characterized in that** the logic unit comprises logic gates in two-value and/or three-value and/or four-value logic.

17. Reconfigurable digital logic unit according to one of the preceding claims, **characterized in that** the logic unit is formed as a field-programmable logic unit.

18. Reconfigurable digital logic unit according to one of Claims 1 to 17, **characterized in that** it is formed as a mask-programmable logic unit.

19. Reconfigurable digital logic unit according to one of the preceding claims, **characterized in that** the cells having the magnetic layer system are arranged one alongside another or one above another.

## Revendications

1. Unité logique numérique reconfigurable (1) avec au moins une porte logique avec des cellules comportant un système de couches magnétiques et dont la résistance peut être modifiée par des impulsions de champ magnétique, laquelle porte logique comprend au moins une première branche de lignes comportant au moins une cellule de données (2) et une deuxième branche de lignes montée en parallèle avec celle-ci et comportant au moins une cellule de référence (3), ainsi qu'un moyen (4) pour évaluer les résistances des première et deuxième branches de lignes, lesquelles résistances constituent une mesure de l'état logique de la porte logique, **caractérisée en ce que** la première branche de lignes comporte au moins deux cellules de données (2) montées en parallèle et **en ce que** les extrémités correspondantes des première et deuxième branches de lignes sont réunies chacune en un noeud de connexion commun.

2. Unité logique numérique reconfigurable selon la revendication 1, **caractérisée en ce que** le moyen d'évaluation des résistances des première et deuxième branches de lignes se présente sous la forme d'un comparateur.

3. Unité logique numérique reconfigurable selon la revendication 1, **caractérisée en ce que** le moyen se présente sous la forme d'un montage en parallèle des première et deuxième branches de lignes et la résistance totale du montage en parallèle est évaluable.

**4.** Unité logique numérique reconfigurable selon l'une des revendications précédentes, **caractérisée en ce que** la deuxième branche de lignes comporte au moins deux cellules de référence (3) montées en parallèle.

**5.** Unité logique numérique reconfigurable selon la revendication 4, **caractérisée en ce que** le nombre de cellules dans la première branche de lignes est différent du nombre de cellules dans la deuxième branche de lignes.

**6.** Unité logique numérique reconfigurable selon l'une des revendications précédentes, **caractérisée en ce que** les première et deuxième branches de lignes comportent des cellules montées en série et/ou en parallèle.

**7.** Unité logique numérique reconfigurable selon l'une des revendications précédentes, **caractérisée en ce que** la sortie d'une porte logique qui comporte préférentiellement une cellule de données et une cellule de référence montée en parallèle est reliée ou peut être reliée à une autre porte pour la commande de celle-ci.

**8.** Unité logique numérique reconfigurable selon l'une des revendications précédentes, **caractérisée en ce que** les cellules (7) de la porte logique présentent le même sens de flux de lecture.

**9.** Unité logique numérique reconfigurable selon l'une des revendications précédentes, **caractérisée en ce que** la résistance d'une cellule (2, 3) peut être modifiée de jusqu'à 60 % par des impulsions de champ magnétique.

**10.** Unité logique numérique reconfigurable selon l'une des revendications précédentes, **caractérisée en ce que**, pour créer une logique trivalente, les résistances dans une branche de lignes sont approximativement identiques et la modification de résistance de la valeur basse à la valeur intermédiaire de la logique trivalente située en dessous de la valeur haute équivaut de préférence approximativement à la moitié de la modification de résistance de la valeur basse à la valeur haute.

**11.** Unité logique numérique reconfigurable selon la revendication 10, **caractérisée en ce que** la porte logique comprend les niveaux de résistance high, medium et low.

**12.** Unité logique numérique reconfigurable selon la revendication 10 ou 11, **caractérisée en ce que** la porte logique peut être utilisée pour l'une des fonctions de porte suivantes : NOR, NAND, OR, AND, const.

**13.** Unité logique numérique reconfigurable selon l'une des revendications 1 à 9, **caractérisée en ce que**, pour créer une logique quadrivalente, la résistance de la première branche de lignes correspond approximativement à 5/3 de la résistance de la deuxième branche de lignes.

**14.** Unité logique numérique reconfigurable selon la revendication 13, **caractérisée en ce que** la porte logique comprend les niveaux de résistance high, medium-high, medium-low et low.

**15.** Unité logique numérique reconfigurable selon la revendication 13 ou 14, **caractérisée en ce que** la porte logique peut être utilisée pour l'une des fonctions de porte suivantes : OR, var, AND, const, NOR, NAND.

**16.** Unité logique numérique reconfigurable selon l'une des revendications précédentes, **caractérisée en ce que** l'unité logique comprend des portes logiques à logique bivalente et/ou trivalente et/ou quadrivalente.

**17.** Unité logique numérique reconfigurable selon l'une des revendications précédentes, **caractérisée en ce que** l'unité logique se présente sous la forme d'une unité logique programmable par champ.

**18.** Unité logique numérique reconfigurable selon l'une des revendications 1 à 17, **caractérisée en ce qu'**elle se présente sous la forme d'une unité logique programmable par masque.

**19.** Unité logique numérique reconfigurable selon l'une des revendications précédentes, **caractérisée en ce que** les cellules comportant le système de couches magnétiques sont situées l'une à côté de l'autre ou sont superposées.

FIG 1

FIG 2

FIG 3

## FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19922129 C1
- DE 10237876 A1